# EUROPEAN PATENT SPECIFICATION

(11) **EP 3 353 808 B1**
(45) Date of publication and mention of the grant of the patent: **29.01.2020**
(21) Application number: 16767055.3
(22) Date of filing: 23.08.2016
(51) Int. Cl.: H01L 27/146, H04N 9/04

(54) **COLOR FILTER SENSORS**
FARBFILTERSENSOREN
CAPTEURS À FILTRES COLORÉS

(30) Priority: 22.09.2015 US 201514861678
(43) Date of publication of application: 01.08.2018
(73) Proprietor: Qualcomm Incorporated, San Diego, CA 92121-1714 (US)
(72) Inventor: GOMA, Sergiu Radu, San Diego, California 92121-1714 (US); ATANASSOV, Kalin Mitkov, San Diego, California 92121-1714 (US); SIDDIQUI, Hasib Ahmed, San Diego, California 92121-1714 (US); HSEIH, Biay-Cheng, San Diego, California 92121-1714 (US); GEORGIEV, Todor Georgiev, San Diego, California 92121-1714 (US)
(74) Representative: Loveless, Ian Mark
(86) International application number: PCT/US2016/048190
(87) International publication number: WO 2017/052898

(56) References cited:
- US-A1- 2002 121 652
- US-A1- 2007 158 772
- US-A1- 2014 191 113
- US-A1- 2014 307 121

## Description

### BACKGROUND OF THE INVENTION

### Field of the Disclosure

The present application relates generally to color filter arrays (CFAs) for digital imaging.

### Description of the Related Art

Image sensors, including complementary metal oxide semiconductor (CMOS) image sensors and charge-coupled devices (CCDs), may be used in digital imaging applications to capture scenes. An image sensor includes an array of sensors. Each sensor in the array includes at least a photosensitive element for outputting a signal having a magnitude proportional to the intensity of incident light or radiation contacting the photosensitive element. When exposed to incident light reflected or emitted from a scene, each sensor in the array outputs a signal having a magnitude corresponding to an intensity of light at one point in the scene. The signals output from each photosensitive element may be processed to form an image representing the captured scene.

To capture color images, photo sensitive elements should be able to separately detect wavelengths of light associated with different colors. For example, a sensor may be designed to detect first, second, and third colors (e.g., red, green and blue wavelengths). To accomplish this, each sensor in the array of sensors may be covered with a single color filter (e.g., a red, green or blue filter). The single color filters may be arranged into a pattern to form a color filter array (CFA) over the array of sensors such that each individual filter in the CFA is aligned with one individual sensor in the array. Accordingly, each sensor in the array may detect the single color of light corresponding to the filter aligned with it.

One example of a CFA pattern is the Bayer CFA, where the array portion consists of rows of alternating red and green color filters and alternating blue and green color filters. Each color filter corresponds to one sensor in an underlying sensor array. In a Bayer CFA, half of the color filters are green color filters, one quarter of the color filters are blue color filters, and one quarter of the color filters are red color filters. The use of twice as many green filters as red and blue filters, respectively, imitates the human eye's greater ability to see green light than red and blue light. In some arrangement, each sensor in the Bayer CFA is sensitive to a different color of light than its closest neighbors disposed in a horizontal and vertical arrangement in the array. For example, the nearest neighbors to each green filter are red and blue filters, the nearest neighbors to each red filter are green filters, and the nearest neighbor to each blue filter are green filters. Because each filter's closest neighbors have different color designations than it, each filter overlies only one corresponding sensor.

Color filter material consists of dyes, or more commonly pigments, to define the spectrum of the color filter. The size of each color filter correspond to the size of the sensor, for example, a 1:1 ratio. However, the manufacturing difficulties and physical limitations in achieving this level of spatial resolution have become impractical for sensors smaller than 1.1 um resolution. Currently, technology trends demand higher image resolution, and hence, smaller sensor size; however, technology cannot reliably reduce pigmentation and dye color filter sizes below 1.1um. It is also more difficult to align the filter elements with their corresponding sensors. Accordingly, new approaches to using CFA's may improve implementations that use sub-micron- sized color image sensors.

United States Patent Application with publication number US 2014/191113 A1 describes a device for color imaging including an optical sensor having light sensitive pixels with a metal film disposed over the light sensitive pixels. The metal film has a group of nano-holes arranged over the pixels according to a periodic lattice formation and is configured to pass light of a preselected first range of wavelengths. The group of nano-holes arranged over an adjoining group of pixels is configured to pass light having ranges of wavelengths different from the first range of wavelengths.

United States Patent Application with publication number US 2002/121652 A1 describes an image pickup apparatus. Each pixel unit of an image pickup element includes first and second photoelectric conversions units and is arranged such that the first sensitivity distribution by the first photoelectric conversion unit and the second sensitivity distribution by the second photoelectric conversion unit overlap in a region between the photoelectric conversion units

### SUMMARY

The scope of protection is defined by the independent claims.

Optional features are included in the dependent claims.

The systems, methods, and devices of the invention each have several aspects, no single one of which is solely responsible for its desirable attributes. Without limiting the scope of this invention as expressed by the claims which follow, some features will now be discussed briefly. After considering this discussion, and particularly after reading the section entitled "Detailed Description" one will understand how the features of this invention provide advantages.

One innovation includes a sensing device including a sensor array comprising a plurality of sensors, each sensor having a length dimension and a width dimension and configured to generate a signal responsive to radiation incident on the sensor, and a filter array comprising a plurality of filters, each filter having a length dimension and a width dimension, the filter array disposed to filter light before it is incident on the sensor array, the filter array arranged relative to the sensor array such that, a first sensor of the sensor array receives radiation propagating through a first filter, and a second sensor of the sensor array receives radiation propagating through at least the first filter and a second filter, wherein the first filter and the second filter are each configured to pass a different wavelength,, where a ratio of the length dimension of each filter to the length dimension of a corresponding sensor that receives light propagating through the filter, a ratio of the width dimension of each filter to the width dimension of a corresponding sensor that receives light propagating through the filter, or both, is a non-integer greater than 1.

Such an innovation may include other aspects. For example, the filter array may include a repeated arrangement of filters, the repeated arrangement including a first filter having a first length and width dimension, configured to pass a first range of wavelengths, a second filter having a second length and width dimension, configured to pass a second range of wavelengths, a third filter having a third length and width dimension, configured to pass a third range of wavelengths, and a fourth filter having a fourth length and width dimension, configured to pass any of the first, second, or third ranges of wavelengths. In one aspect, the repeated arrangement of filters are arranged so that the first filter is disposed over a first sensor and over at least a portion of at least three other sensors adjacent to the first sensor. In another aspect, the ratio of the length dimension of a filter to the length dimension of a corresponding sensor is a non-integer greater than 1. In another aspect, a ratio of the width dimension of a filter to the width dimension of a corresponding sensor is a non-integer greater than 1. In another aspect, at least some of the plurality of sensors are positioned relative to the filter elements to receive radiation filtered by no more than two of the first, second, third and fourth filters. In another aspect, the length dimensions of the first filter, the second filter, the third filter, and the fourth filter are equal. In another aspect, the width dimensions of the first filter, the second filter, the third filter, and the fourth filter are equal. In another aspect, the first filter passes light wavelengths in a range of about 570 nm to about 750 nm, the second filter passes light wavelengths in a range of about 450 nm to about 590 nm, and the third filter passes light wavelengths in a range of about 380 nm to about 570 nm. In another aspect, the filter array comprises a polymeric material. In another aspect, each of the plurality of sensors comprises a light receiving surface that defined by an area dimension that is substantially the same size. In another aspect, the sensing device may be configured wherein a distance from a center of one sensor to a center of an adjacent sensor is less than 1.1µ.m. In another aspect, the ratio of the length dimension of a filter and the length dimension of a corresponding sensor is between 1.0 and 2.0. In another aspect, the ratio of the width dimension of a filter and the width dimension of a corresponding sensor is between 1.0 and 2.0.

Another innovation includes a method, including filtering light propagating towards a sensor array with a filter array comprising a plurality of filters, the filter array positioned relative to the sensor array to filter the light before it is incident on the sensor array, each filter having a length dimension and a width dimension, receiving the filtered light on the sensor array, the sensor array comprising a plurality of sensors each configured to generate a signal responsive to light incident on the sensor, the sensor array arranged relative to the filter array such that a first sensor of the sensor array receives radiation propagating through a first filter, and a second sensor of the sensor array receives radiation propagating through at least the first filter and a second filter, wherein the first filter and the second filter are each configured to pass a different range of filtered light, wherein each sensor has a length dimension and a width dimension, and wherein a ratio of the length dimension of each filter to the length dimension of a corresponding sensor that receives light propagating through the filter, a ratio of the width dimension of each filter to the width dimension of a corresponding sensor that receives light propagating through the filter, or both, is a non-integer greater than 1.

Such an innovation may include other aspects. For example, in one aspect the filter array comprises a repeated arrangement of filters, the repeated arrangement including a first filter having a first length and width dimension, configured to pass a first range of wavelengths, a second filter having a second length and width dimension, configured to pass a second range of wavelengths, a third filter having a third length and width dimension, configured to pass a third range of wavelengths, and a fourth filter having a fourth length and width dimension, configured to pass any of the first, second, or third ranges of wavelengths. In some aspects, the repeated arrangement of filters are arranged so that the first filter is disposed over a first sensor and over at least a portion of at least three other sensors adjacent to the first sensor. In another aspect, the ratio of the length dimension of a filter to the length dimension of a corresponding sensor is a non-integer greater than 1. In another aspect, a ratio of the width dimension of a filter to the width dimension of a corresponding sensor is a non-integer greater than 1. In another aspect, the first filter passes light wavelengths in a range of about 570 nm to about 750 nm, the second filter passes light wavelengths in a range of about 450 nm to about 590 nm, and the third filter passes light wavelengths in a range of about 380 nm to about 570 nm.

### BRIEF DESCRIPTION OF THE DRAWINGS

Figure 1 illustrates a simplified example of a 6x6 portion of a sensor array.
Figure **2** illustrates a simplified example of a 4x4 portion of a color filter array.
Figure **3** illustrates the example of Figure 2 with an alternative color filter array configuration.
Figure **4** illustrates the example of Figures 2 and 3 with an alternative color filter configuration.
Figure **5** illustrates a 6x6 portion of a sensor array with a 4x4 portion of a color filter applied to it, where the length and width of color filter elements are 1.5x of the sensors.
Figure **6** illustrates the example of Figure 3, emphasizing the color filter elements against the sensor area, where the length and width of color filter elements are 1.5x of the sensors.
Figure **7** illustrates an example of a size reduced pattern of a color filter array and sensor array where the length and width of color filter elements are 1.5x of the sensors.
Figure **8** illustrates an example of a 1.5:1 color filter element to sensor element configuration.
Figure **9** illustrates an example of a color filter arrangement having a 3x3 pattern that may be repeated throughout the filter.
Figure **10** illustrates an example of a configuration where the color filter elements are 2.5x the size of the sensors.
Figure **11** illustrates an example of a configuration where the color filter elements are 1.1x the size of the sensors.
Figure **12** illustrates an example of a size reduced pattern of a color filter array and sensor array where the length and width of color filter elements are 1.5x of the sensors, and the sensors of the sensor array have an aspect ratio of 2:1.
Figure **13** illustrates an example of a 1.5:1 color filter element to sensor element configuration where the sensors have an aspect ratio of 2:1.

### DETAILED DESCRIPTION

The word "exemplary" is used herein to mean "serving as an example, instance, or illustration." Any embodiment described herein as "exemplary" is not necessarily to be construed as preferred or advantageous over other embodiments.

The term "non-integer ratio" is used herein to define a ratio where at least one of the numbers of the ratio will be expressed with a fractional component when the ratio is simplified such that the first number of the ratio or the second number of the ratio is "1." For example, a ratio of 1:1.5 contains the number 1 being a whole number, and the number 1.5 being expressed with a fractional component; the fractional component being the "0.5" or one-half. In the context of the ratios described herein, any two things measured with respect to each other may not be the exact size described, but the numbers herein are meant to be described such that the two things are substantially equal to the measurement expressed.

The term "about" and "substantially" as used herein indicates a tolerance within 10% of the measurement expressed, unless otherwise stated.

The term "light" as used herein refers to wavelengths of radiation that are visible and non-visible to a human eye.

The words "color filter array," "filter array," and "filter element" are broad terms and are used herein to mean any form of filtering technology associated with filtering spectrums of electromagnetic radiation, including visible and non-visible wavelengths of light.

The term "image sensor" as used herein may also be referred to as a "sensor."

The term "color filter array" or CFA may be referred to as a "filter array," "color filters," "RGB filters," or "electromagnetic radiation filter array." When a filter is referred to as a red filter, a blue filter, or a green filter, such filters are configured to allow light to pass through that has one or more wavelengths associated with the color red, blue, or green, respectively.

The term "respective" is used herein to mean the corresponding apparatus associated with the subject. When a filter is referenced to a certain color (e.g., a red filter, a blue filter, a green filter) such terminology refers to a filter configured to allow the spectrum of that color of light to pass through (e.g., wavelengths of light that are generally associated with that color).

The following detailed description is directed to certain specific embodiments of the invention. However, the invention can be embodied in a multitude of different ways. It should be apparent that the aspects herein may be embodied in a wide variety of forms and that any specific structure, function, or both being disclosed herein is merely representative. Based on the teachings herein one skilled in the art should appreciate that an aspect disclosed herein may be implemented independently of any other aspects and that two or more of these aspects may be combined in various ways. For example, an apparatus may be implemented or a method may be practiced using any number of the aspects set forth herein. In addition, such an apparatus may be implemented or such a method may be practiced using other structure, functionality, or structure and functionality in addition to, or other than one or more of the aspects set forth herein.

The examples, systems, and methods described herein are described with respect to digital camera technologies. The systems and methods described herein may be implemented on a variety of different photosensitive devices, or image sensors. These include general purpose or special purpose image sensors, environments, or configurations. Examples of photosensitive devices, environments, and configurations that may be suitable for use with the invention include, but are not limited to, semiconductor charge-coupled devices (CCD) or active sensors in CMOS or N-Type metal-oxide-semiconductor (NMOS) technologies, all of which can be germane in a variety of applications including: digital cameras, hand-held or laptop devices, and mobile devices (e.g., phones, smart phones, Personal Data Assistants (PDAs), Ultra Mobile Personal Computers (UMPCs), and Mobile Internet Devices (MIDs)).

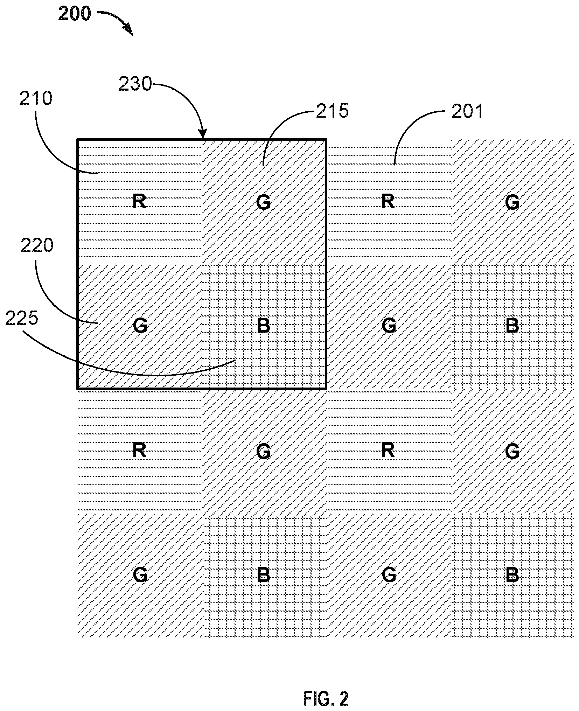

Embodiments disclosed herein may include a solution for overcoming the manufacturing difficulties associated with producing a sub-micron sensor (e.g., a sensor below 1.1 µm in size) with a Color Filter Array (CFA) (for example, Figure 2) that can provide accurate filter function for individual sensors. Current state-of-the-art CFA technology can only support sensor sizes down to about 1.1µm in resolution using the standard 1:1 color filter-to-sensor ratio. To accommodate smaller sensor sizes while maintaining acceptable color error and achieving high color fidelity and uniformity, individual color filter elements may extend across multiple sensors, and individual sensors may share portions of multiple color filter elements that mask separate segments of an individual sensors.

In some examples, a fractional color filter-to-sensor ratio is used where the size of each individual color filter element of the CFA is greater than the size of the sensors in the sensor array. The result is an overlap of the multiple colors on individual sensors. For example, in an embodiment where the color filters are 1.5x the size of the individual sensors (e.g., a 1.5:1 ratio), and the colors used in the color filters are Red, Green, and Blue (RGB), the combination of colors as seen by the sensors through the color filters can expand the spectrum of colors beyond RGB to also include Cyan, Yellow, and White, representing the expanded spectrum of light seen by individual sensors.

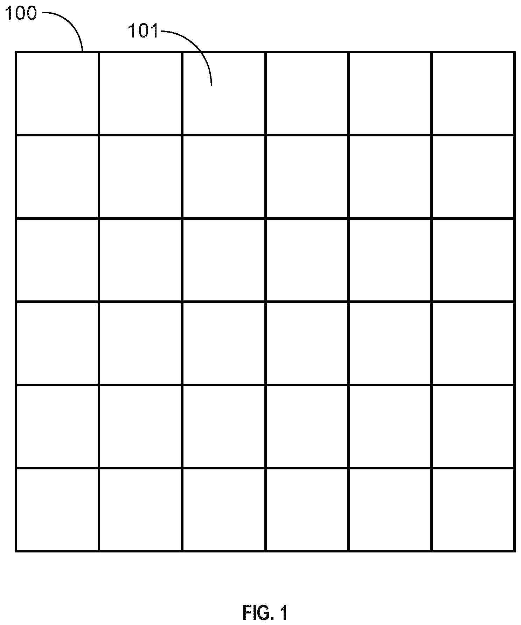

Figure 1 illustrates an example array of sensors (or sensors) **100,** where each individual sensor **101** is represented as a square having a 1:1 sensor aspect ratio, having the width of the individual sensor **101** substantially equal to the length of that individual sensor **101.** This example should not be read as limiting, as the present invention may be applied to an array of sensors **100** using an alternative sensor element aspect ratio (e.g., sensor aspect ratio 2: 1, 4:3, and 5:4). Figure 1 provides an example 6x6 square array of sensors **100,** including 36 individual sensors in total. This example should not be read as limiting, as various implementations may be applied to a sensor array containing any number of sensors.

In one example embodiment, the array of sensors **100** may comprise a semiconductor CCD, or any device consisting of a photoactive region (or an epitaxial layer of silicon) integrated with a transmission region coupled to a shift register. In an example embodiment of a CCD for capturing images, an image may be projected through a lens onto the array of sensors **100** that includes a capacitor array, causing each capacitor to accumulate an electric charge proportional to the light intensity at that location.

Alternatively, the array of sensors **100** may comprise an active sensor (also referred to herein as a CMOS sensor), or any device consisting of an integrated circuit containing an array of sensors **100,** each sensor containing a photodetector and an active amplifier. In this embodiment, the array of sensors **100** may be arranged in rows and columns. In some examples, individual sensors in a given row may share reset lines, so that a whole row may be reset at one time. The row select lines of each sensor in a row may also be connected.. The output of each sensor in any given column are may be connected to together forming a single output terminal (or line). Only one row is selected at a given time, so no "competition" for the output line occurs. Amplifier circuitry to amplify sensor output may be provided on a column basis.

In another example embodiment, the array of sensors **100** may comprise an NMOS, or any image sensor consisting of n-type transistors to construct the on-chip logic of an image sensor.

Figure 2 illustrates an example color filter array (CFA) **200** that includes an array of individual filters. In Figures 2, 3 and 8, an illustrated pattern of horizontal lines, diagonal lines, and cross-hatching of vertical lines and horizontal lines is merely a depicted representation of a filter and such lines do not represent any physical structure of a filter. In this example, the CFA **200** is made up of a 4x4 CFA **200** illustrated as patterned squares, each square representing an individual filter **201** designed to pass a particular range of wavelengths, and each square labeled with an alphabetical letter representative of the color of light that may pass through that particular filter: the letter R referring to red, the letter G referring to green, and the letter B referring to blue. The CFA **200** may comprise a 2x2 filter array that represents a repeatable pattern of recurring filter elements **230** as illustrated by the bold border square in the upper left-hand corner of the CFA **200** of Figure 2. For example, the pattern of recurring filter elements **230** can include a first filter element **210,** located in the top left hand corner of the pattern of recurring filter elements **230,** which is represented in Figure 2 by a horizontal line pattern and the letter "R" in the center indicating the first filter element **210** is a red filter configured to pass light having one or more wavelengths associated with the color red. The pattern of recurring filter elements **230** may also include a second filter element **215** disposed adjacent and to the right of the first filter element **210** and a third filter element **220** disposed adjacent and below the first filter element **210.** The second filter element **215** and third filter element **220** are both illustrated as having a diagonal line pattern with the letter "G" in the center, indicating both the second filter element **215** and third filter element **220** are green filters configured to pass light having one or more wavelengths associated with the color green. The pattern of recurring filter elements **230** may also include a fourth filter element **225** located directly adjacent to both the second filter element **215** and third filter element **220** and diagonally adjacent to the first filter element **210.** The fourth filter element **225** is illustrated as a square with a cross-hatch pattern of vertical and horizontal lines, and containing the letter "B" indicating a blue filter configured to pass light having one or more wavelengths generally associated with the color blue. This 2x2 arrangement, an example of a pattern of recurring filter elements **230** (illustration emphasized by a square with thick boundary lines) is repeated to create the 4x4 CFA **200** illustrated by Figure 2.

The CFA **200** may mask an array of sensors 100 in order to filter radiation and allow only a specific range of wavelengths, such that each individual filter **201** included in the CFA **200** allows the corresponding sensors to be exposed to only a specific range of the electromagnetic spectrum, based on the configuration of the individual filters, for example, first filter element **210,** second filter element **215,** third filter element **220,** and fourth filter element **225** of the CFA **200.** Figure 2 is an example that illustrates the Bayer filter configuration discussed above, where the RGB color filters limit the light exposed to the sensors to RGB wavelength regions. This example should not be read as limiting, as the present invention may comprise alternative configurations of color patterns and size of color filters, as well as filters that allow for passing ranges of electromagnetic frequencies that include infrared, ultra-violet, or other ranges of the electromagnetic spectrum beyond visible light.

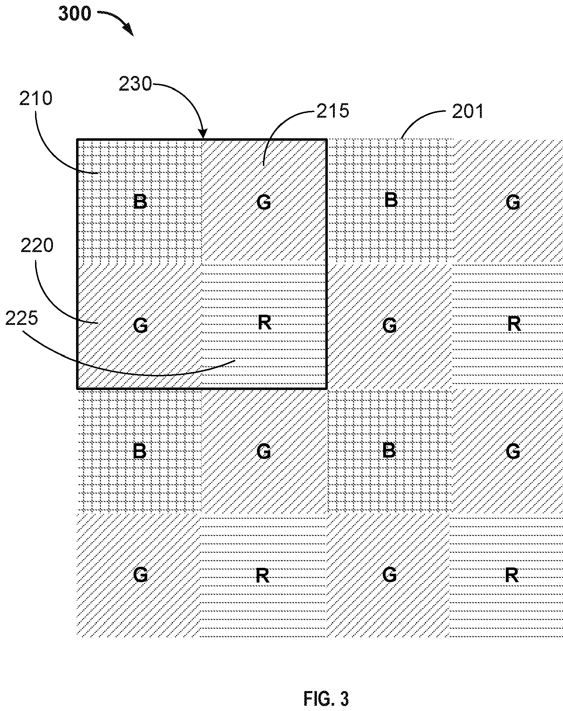

For example, Figure 3 illustrates an alternative CFA configuration that includes a 2x2 filter array representative of a repeatable pattern of recurring filter elements **230** as illustrated by the bold border square in the upper left-hand corner of the CFA **300.** The pattern of recurring filter elements **230** can include a first filter element **210,** located in the top left hand corner of the pattern of recurring filter elements **230,** which is represented in Figure 3 by a square with a cross-hatch pattern of vertical and horizontal lines, and containing the letter B indicating a blue filter. The pattern of recurring filter elements **230** may also include a second filter element **215** disposed adjacent and to the right of the first filter element **210** and a third filter element **220** disposed adjacent and below the first filter element **210.** The second filter element **215** and third filter element **220** are both illustrated as having a diagonal line pattern with the letter G in the center, indicating both the second filter element **215** and third filter element **220** are green filters. The pattern of recurring filter elements **230** may also include a fourth filter element **225** located directly adjacent to both the second filter element **215** and third filter element **220** and diagonally adjacent to the first filter element **210.** The fourth filter element **225** is illustrated as a horizontal line pattern and the letter R in the center indicating the fourth element **225** is a red filter. This 2x2 arrangement, an example of a pattern of recurring filter elements **230** (illustration emphasized by a square with thick boundary lines) is repeated to create the 4x4 CFA **300** illustrated by Figure 3.

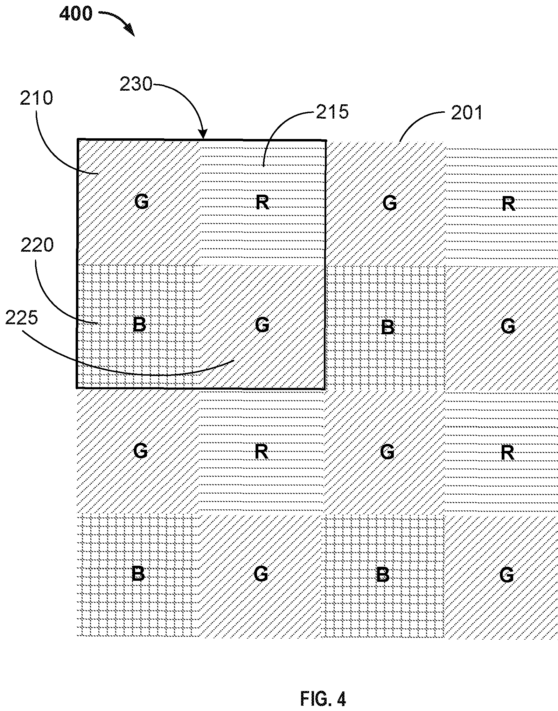

Another example of an alternative configuration is provided in Figure 4. Figure 4 illustrates an alternative CFA configuration that includes a 2x2 filter array that represents a repeatable pattern of recurring filter elements **230** as illustrated by the bold border square in the upper left-hand corner of the CFA **400.** For example, the pattern of recurring filter elements **230** can include a first filter element **210,** located in the top left hand corner of the pattern of recurring filter elements **230,** which is represented in Figure 4 as a square having a diagonal line pattern with the letter G in the center, indicating that the first filter element **210** is a green filter designed to pass an associated wavelength. The pattern of recurring filter elements **230** may also include a second filter element **215** disposed adjacent and to the right of the first filter element **210** and a third filter element **220** disposed adjacent and below the first filter element **210.** The second filter element **215** is illustrated as a horizontal line pattern and the letter R in the center to indicate the general range of passable wavelengths. The third filter element **220** is illustrated as having cross-hatch pattern of vertical and horizontal lines, and containing the letter B indicating a blue filter designed to pass an associated wavelength. The pattern of recurring filter elements **230** may also include a fourth filter element **225** located directly adjacent to both the second filter element **215** and third filter element **220** and diagonally adjacent to the first filter element **210.** The fourth filter element **225** is illustrated as a diagonal line pattern with the letter G in the center, indicating that the fourth filter element **225** is a green filter designed to pass an associated wavelength. This 2x2 arrangement, an example of a pattern of recurring filter elements **230** (illustration emphasized by a square with thick boundary lines) is repeated to create the 4x4 CFA **400** illustrated by Figure 4.

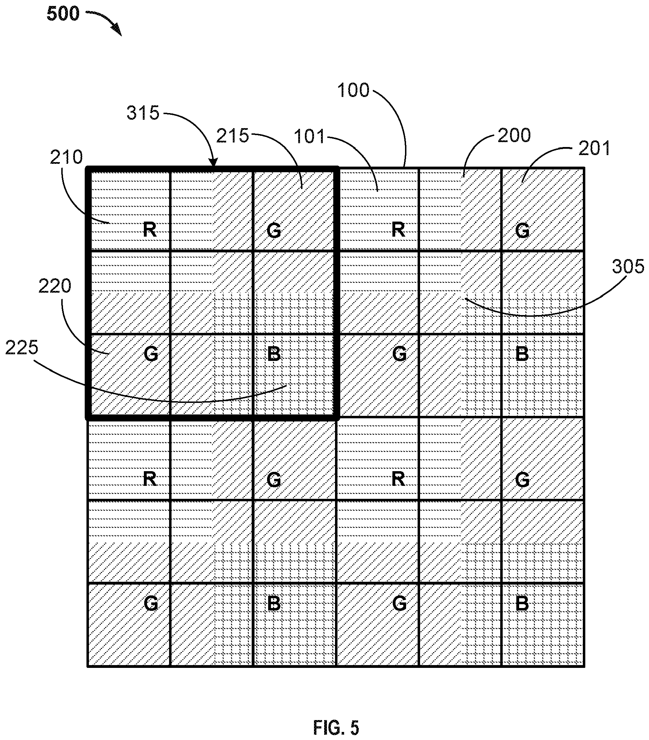

As previously discussed, the size of each individual filter **201** of a typical CFA **200,** when compared to the size of an individual sensor **101** in the array of sensors **100,** operate using a 1:1 ratio, where an individual filter **201** designed to filter a specific range of wavelengths corresponds to a single sensor and is disposed contiguous to that single sensor. For example, an individual filter of a typical CFA corresponds to an individual sensor such that the light being filtered by the filter propagates to only that sensor. Figure 5 illustrates an example embodiment, where the size ratio of each individual filter **201** of the CFA **200** to each individual sensor **101** of the array of sensors **100** is 1.5:1. In this example, each individual filter **201** is 1.5 times the length and the width of the individual sensor **101** it is disposed over, causing each individual filter **201** to be disposed over multiple sensors. Figure 5 further illustrates the 6x6 array of sensors **100** of Figure 1 merged into the CFA **200** of Figure 2 to provide an example configuration of the CFA **200** and array of sensors **100** embodied in the present invention. In this configuration, the individual filters of the CFA **200** are 1.5x the size of the individual sensors of the array of sensors **100,** and each individual sensor **101** is of a standard 1:1 length and width ratio having the width of the individual sensor **101** substantially equal to the length of that individual sensor **101.** This configuration may create instances of up to four separate adjacent filters disposed over a center sensor **305** once in every 3x3 array of nine sensors **310** as explained in more detail below. This example should not be read as limiting.

As previously mentioned, Figure 5 illustrates how the example configuration can result in an individual sensor **101** being masked by more than one individual filter **201.** In this example, center sensor **305** may be masked by two green filters, a red filter, and a blue filter, the filters each covering one-quarter of the light sensing surface of the sensor. The two sensors directly **510, 520** above and directly to the left of center sensor **305** are each masked by two filters, where half of the light sensing surface of the sensors are masked by a red filter, and the other half by a green filter. The two sensors **525, 515** directly below and directly to the right of the center sensor **305** are each masked by two filters, where half of the light sensing surface of the sensors are masked by a blue filter, and the other half by a green filter. This creates the added benefit of expanding the spectral range filtered to certain sensors to include not just red, green, and blue wavelengths, but also cyan, yellow, and white (RGBCYW).

The CFA **200** in Figure 5 is a mosaic of individual color filters. The CFA **200** is made up of a 4x4 CFA **200** illustrated as patterned squares, each square representing an individual filter **201** and labeled with an alphabetical letter representative of the color of light that may pass through that particular filter. The letter R referring to red, the letter G referring to green, and the letter B referring to blue. The CFA **200** includes a first filter element **210,** located in the top left hand corner of the matrix, which is made up of a horizontal line pattern and the letter R in the center to indicate the general range of passable wavelengths. The CFA **200** also includes a second filter element **215** disposed adjacent to the first filter element **210** and to the right of the first filter element **210** (relative to Figure 5 orientation) and a third filter element **220** disposed adjacent to the first filter element **210** and below first filter element **210** (relative to Figure 5 orientation). Second filter element **215** and third filter element **220** are both illustrated as having a diagonal line pattern with the letter G in the center, indicating both the second filter element **215** and the third filter element **220** are green filters designed to pass an associated wavelength. The CFA also includes a fourth filter element **225** located directly adjacent to both the green filters **215, 220** and diagonally adjacent to the red filter **210,** is made up of a cross-hatch pattern of vertical and horizontal lines, and contains the letter B indicating a blue filter.

Figure 5 further illustrates an example configuration **500** of a recurring element **315** in the array of sensors **100** and filter CFA **200** configuration. The recurring element **315** is emphasized by a dark outlined square in the upper left corner of Figure 5, the dark outlined square containing nine individual sensors in a square, 3x3 formation and four color filter elements in a square 2x2 formation disposed over the individual sensors. The four color filter elements representing red **210,** green **215,** blue **225,** and green **220,** respectively (clockwise from upper left corner).

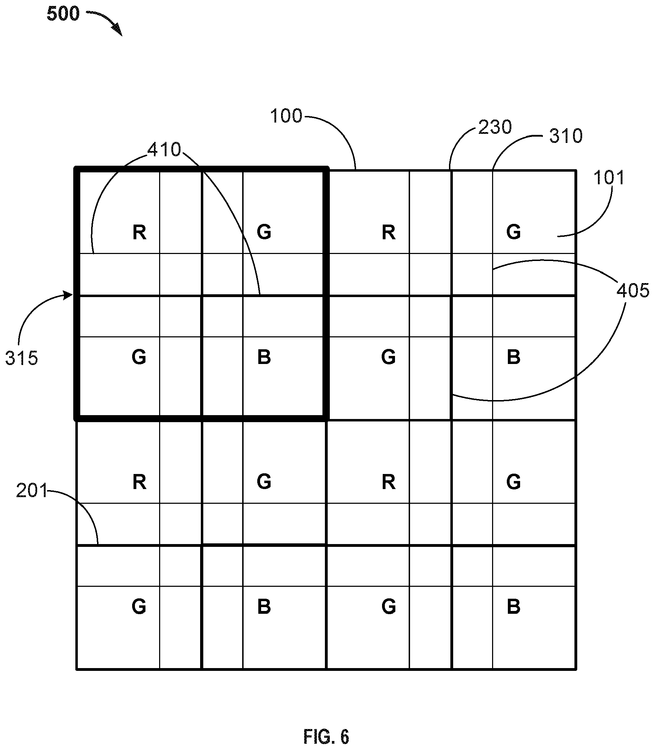

Figure 6 provides an exemplary view of a pattern of recurring filter elements **230** and array of sensors **100** where the individual filters **201** are demarcated in the Figure by thick boundary lines and the array of sensors 100 is demarcated by thinner lines to provide an additional perspective of one embodiment of the present invention where the CFA **200** to array of sensors 100 ratio is 1.5:1. Figure 6 is provided to show clarity of an example embodiment of the invention, and comprises a combination of Figure 1 and Figure 2, but removes the patterns contained in Figure 2, and instead uses vertical **405** and horizontal **410** boundary lines to illustrate an example embodiment of the invention. Light-weighted boundary lines denote the boundaries of each individual sensor **101,** while the heavier weighted lines denote the boundaries of each individual filter **201.** Note that the lines are depicted only for visualization purposes.

Figure 6 further illustrates an example of a recurring element **315** in the array of sensors 100 and filter CFA **200** configuration. The recurring element **315** is emphasized by a dark outlined square in the upper left corner of Figure 6, the dark outlined square containing nine individual sensors in a square, 3x3 formation, and four color filter elements in a square, 2x2 formation adjacent to the individual sensors. The four color filter elements representing red, green, blue, and green, respectively (clockwise from upper left corner).

Figures 5 and 6 both provide an additional exemplary view of the recurring pattern of a CFA **200** and the array of sensors 100 using the 1.5:1 ratio defined in Figures 3 and 4.

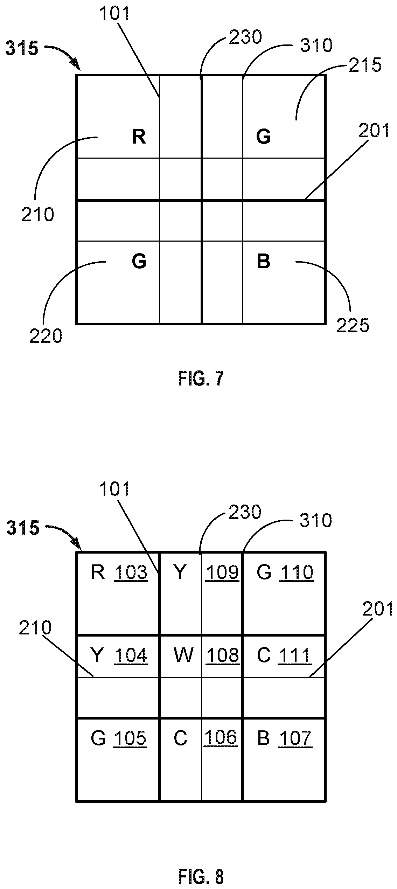

Figure 7 comprises a 2x2 arrangement, an example pattern of recurring filter elements **230** (emphasized using thick borders around each filter element for visualization purposes) enclosing four squares, each square representing in individual filter **201** in an array of four color filters, the top left filter (e.g., first filter element **210)** containing a letter R for red, the two immediately adjacent to the second filter element **215** and the third filter element **220** containing the letter G referring to green, and the fourth filter element **225** letter B referring to blue. The color labels of these filters generally representing the wavelength allowed to pass through each filter. The 2x2 color filter array of Figure 7 is disposed adjacent to the 3x3 array of nine sensors **310** such that the ratio of color filters to sensors is 1.5:1, resulting in the 2x2 arrangement of color filters substantially matching the 3x3 array of nine sensors **310.**

Figure 8 illustrates the concept discussed briefly above where the use of multiple color filters on one sensor expands the spectrum of colors from RGB to RGBCYW. In this example embodiment, the 2x2 color filter array may be disposed over the 3x3 array of nine sensors **310** (emphasized using thick borders around each sensor element for visualization purposes) such that the ratio of color filters to sensors is 1.5:1. This results in the 2x2 arrangement of color filters substantially matching the 3x3 array of nine sensors **310.** Here, the first sensor **103** can be masked completely by a first filter element **210,** where the first filter element **210** may be configured to pass a spectrum of red light. Thus, the first sensor **103** may be exposed to a spectrum of light that is limited by the first filter element **210.** A second sensor **104,** situated substantially below (in the orientation of Figure 8) the first sensor **103,** may be masked by two CFA filters (in this example, the first filter element **210** and a second filter element **215).** Each CFA filter element may be positioned to mask portions of the second sensor **104.** In this example, the second sensor **104** may be exposed to a combination of green and red wavelengths resulting in a light spectrum that can be broad enough to include orange (590-620 nm wavelength), yellow (570-590 nm wavelength), and lighter shades of green (490-550 nm wavelength) to the second sensor **104.** A third sensor **109,** which lies adjacent and directly to the right of the first sensor **103,** may experience the same broad spectrum of light caused by a similar combination of filter elements. The third sensor **109** may be masked by the first filter element **210** and the second filter element **215.** Due to both the second sensor **104** and third sensor **109** experiencing a broader spectrum of radiation that may include the color yellow, both sensors are labeled with a "Y."

Figure 8 further illustrates a fourth sensor **105** on the bottom row of the 3x3 array of nine sensors **310** adjacent to, and directly below the second sensor **104.** The 2x2 filter matrix can be arranged so that the fourth sensor **105** is masked completely by the third filter element **220,** where the third filter element **220** may be configured to pass a spectrum of green light. Thus, a light sensing element of the fourth sensor **105** may be exposed to a spectrum of light that is limited by the third filter element **220.** A fifth sensor **110,** which lies adjacent and directly to the right of the third sensor **109,** may experience the same filtered light spectrum as the fourth sensor **105.** Due to both the fourth sensor **105** and fifth sensor **110** experiencing a spectrum of radiation that may be limited to the color green, both sensors are labeled with a "G."

Additionally, Figure 8 further illustrates a sixth sensor **106** on the bottom row of the 3x3 array of nine sensors **310** adjacent and directly to the right (in the orientation of Figure 8) of the fourth sensor **105.** The sixth sensor **106** can be masked by two individual CFA filters (in this example, the third filter element **220** and the fourth filter element **225**)**.** Each CFA filter element may be positioned to mask portions of the sixth sensor **106.** In this example, the sixth sensor **106** may be exposed to a combination of green and blue wavelengths resulting in a light spectrum that can include the color cyan (490-520 nm wavelength). A seventh sensor **111,** which lies adjacent and directly below (in the orientation of Figure 8) the fifth sensor **110,** may experience the same spectrum of light caused by the combination of filter elements masking the sixth sensor **106.** The seventh sensor **111** can be masked by the second filter element **215** and the fourth filter element **225.** Due to both the sixth sensor **106** and seventh sensor **111** experiencing a broad spectrum of radiation that may include the color cyan, both sensors are labeled with a "C."

Figure 8 further illustrates an eighth sensor **107** on the bottom row of the 3x3 array of nine sensors **310** adjacent to, and directly below (in the orientation of Figure 8) the seventh sensor **111.** The 2x2 filter matrix can be arranged so that the eighth sensor **107** is masked completely by the fourth filter element **225,** where the fourth filter element **225** may be configured to pass a spectrum of blue light. Thus, a light sensing element of the eighth sensor **107** may be exposed to a spectrum of light that is limited by the fourth filter element **225.** Due to the eighth sensor **107** experiencing a spectrum of radiation that may be limited to the color blue, it is labeled with a "B."

Figure 8 illustrates a ninth sensor **108** in the center of the 3x3 array of nine sensors **310.** The 2x2 filter matrix can be arranged so that the ninth sensor **108** is masked 25% by the first filter element **210,** 25% by the second filter element **215,** 25% by the third filter element **220,** and 25% by the fourth filter element **225.** Thus, a light sensing element of the ninth sensor **108** may be exposed to a spectrum of light that is broader than the spectrum exposed to the remaining sensors in the 3x3 array of nine sensors **310.** Due to the broad spectrum of light that the ninth sensor **108** may be exposed to, it is labeled with a "W" indicating that the pixel may be exposed to a mixture of the frequencies allowed by the filter elements. The resulting array has an effective sensor composition of 11% R, W, and B, respectively and 22% G and C, respectively.

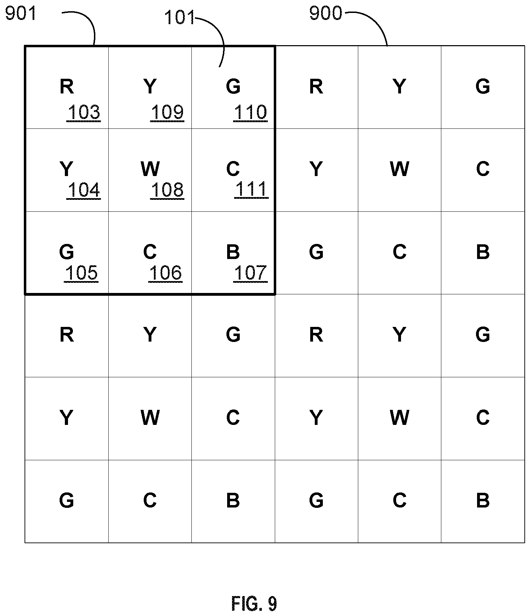

Figure 9 illustrates the example embodiment of Figure 8 applied to the array of sensors 100 of Figure 1. Figure 9 also includes one letter labels on each individual sensor 101 identifying the spectrum of light exposed to the individual sensor 101 using the example embodiment described in Figure 8.

Figure 9 shows a 6x6 array of small squares representative of a sensor array **900,** or a portion of a sensor array **900,** with each square containing an alphabetical letter. The array **900** can be viewed as being a repeated pattern of four, 3x3 sensor arrays. Each 3x3 sensor array **901** containing a first sensor **103** (represented by a first square) in the top left corner representing a sensor and containing the letter R signifying the light received by that sensor is red. The two sensors **104, 109** immediately adjacent to the top left sensor **103** and containing the letter "Y" indicating light received by those sensors is yellow. Directly adjacent to both yellow sensors **104, 109,** and diagonally adjacent to the red sensor **103** is a sensor labeled with a "W" (ninth sensor **108**), indicating that the ninth sensor **108** receives white light due to the combination of RGB filters (e.g., the four filter elements previously discussed) overlapping the ninth sensor **108.** Diagonally adjacent to the ninth sensor **108** and directly adjacent to the yellow sensors **104, 109** are two sensors **105, 110** with the letter "G" signifying that this sensor receives a green light due to the green color filter. Directly adjacent to the ninth sensor **108** and on opposite ends of the ninth sensor **108** in relation to the yellow sensors, are two sensors **106, 111** labeled with the letter "C." The color these sensors are exposed to is cyan due to the overlap of green and blue filters over these sensors (sixth sensor **106** and seventh sensor **111**). Finally, directly adjacent to the cyan sensors (sixth sensor **106** and seventh sensor **111**) and diagonally adjacent to a ninth sensor **108** is a sensor labeled with a B (eighth sensor **107**), which represents a sensor that receives light that propagates through a blue filter.

As explained below, the size of the individual filter **201** may vary with respect to the individual sensor **101,** resulting in varying spectrums of light exposed to the individual sensor 101 masked by a plurality of individual color filters. To illustrate this, in a 1.1:1 CFA **200** to array of sensors **100** ratio (discussed below) where the filter element is only 1.1 times larger than a corresponding sensor element, second sensor **104** would have a much smaller spectrum of red light with respect to the spectrum of green light it receives.

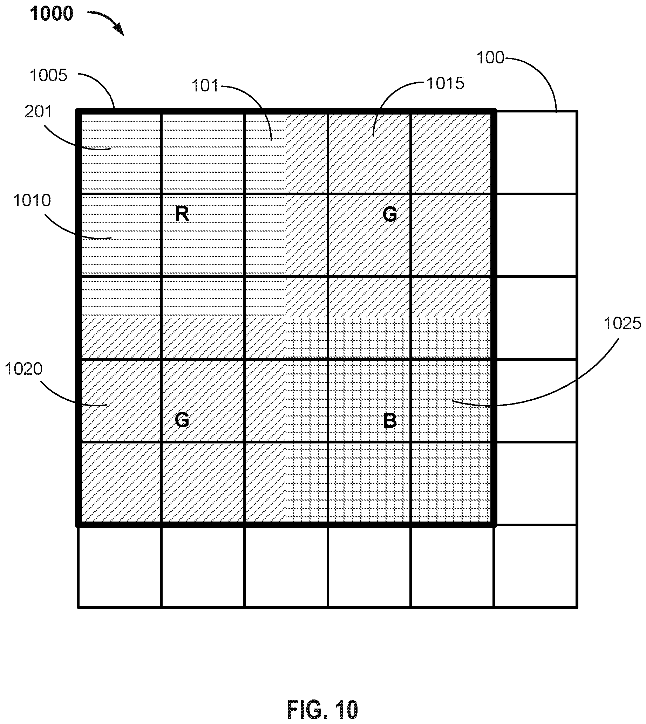

Figure 10 illustrates an example configuration where the individual color filters are 2.5x the size of the individual sensor **101.** Similar to Figure 5, Figure 10 provides a 6x6 array of sensors **100** merged with an electromagnetic radiation filter array **1005.** It should be noted that the size of the individual filter **201** may vary with respect to the size and shape of the individual sensor **101.**

Figure 10 illustrates an example embodiment **1000,** where the size ratio of individual filter **201** of the electromagnetic radiation filter array **1005** to each individual sensor **101** of the array of sensor elements **100** is 2.5:1. In this example, the length of an individual filter **201** is 2.5 times the length and the width of an individual sensor **101.** In this configuration, each individual sensor **101** is of a standard 1:1 length and width ratio having the width of the individual sensor **101** substantially equal to the length of that individual sensor **101.** This configuration may create instances of up to four separate filters disposed adjacent to center sensor **305** once in every group of thirty-six sensors as explained in more detail below. This example should not be read as limiting, as the present invention may be applied to an array of sensor elements **100** using an alternative sensor aspect ratio (e.g., sensor aspect ratio 2:1, 4:3, 5:4, etc.), or electromagnetic radiation filter array **1005** using an alternative aspect ratio.

The electromagnetic radiation filter array **1005** in Figure 10 includes a mosaic of individual color filters. The electromagnetic radiation filter array **1005** is made up of a 2x2 filter array illustrated as patterned squares, each square representing an individual filter **201** and labeled with an alphabetical letter representative of the color of light that may pass through that particular filter. In this example, the letter R referring to red, the letter G referring to green, and the letter B referring to blue. The electromagnetic radiation filter array **1005** includes a first filter **1010,** located in the top left hand corner of the matrix, which is made up of a horizontal line pattern and the letter R in the center to indicate an example range of passable wavelengths. The electromagnetic radiation filter array **1005** also includes a second filter **1015** disposed adjacent and directly to the right (in the orientation of Figure 10) of the first filter element **210,** and a third filter **1020** disposed adjacent and directly below the first filter **1010.** Second filter **1015** and third filter **1020** are both illustrated as having a diagonal line pattern with the letter G in the center, indicating both the second filter **1015** and third filter **1020** are designed to pass an associated wavelength. The CFA **200** also includes a fourth filter **1025** located directly adjacent to both the second filter **1015** and third filter **1020** and diagonally adjacent to the first filter **1010,** is made up of a cross-hatch pattern of vertical and horizontal lines, and contains the letter B to indicate an example range of passable wavelengths.

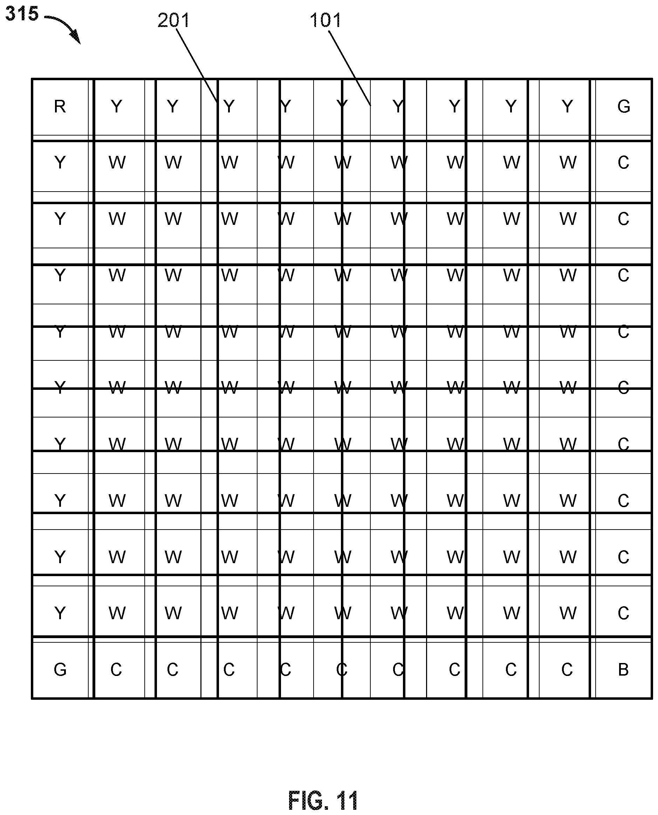

Figure 11 illustrates an example embodiment where the size ratio of individual filter **201** to a corresponding sensor **101** is 1.1:1. In this example, the length of an individual filter **201** is 1.1 times the length and the width of an individual sensor **101.** In this configuration, each individual sensor **101** is of a standard 1:1 length and width ratio having the width of the individual sensor **101** substantially equal to the length of that individual sensor **101.**

The recurring element **315** in the array of sensor elements and filter CFA configuration of Figure 11 includes a 10x10 matrix of filter elements, and an 11x11 matrix of sensor elements. The filter elements are emphasized with a bolder outline than the boundary of the sensor elements for visualization purposes. Each sensor element is labeled with a letter indicating the range of electromagnetic radiation it is exposed to. For example, sensor elements containing the letter R refers to red, G refers to green, B refers to blue, C refers to cyan, Y refers to yellow, and W refers to white. It is noted that in this example configuration that there is a large number of sensor elements exposed to all three spectrums of R, G, and B. This kind of configuration may be a useful CFA for photodiodes that respond to all colors of light; that is, where some or all of the sensor elements are "panchromatic", and more of the light is detected, rather than absorbed, compared to the traditional Bayer matrix.

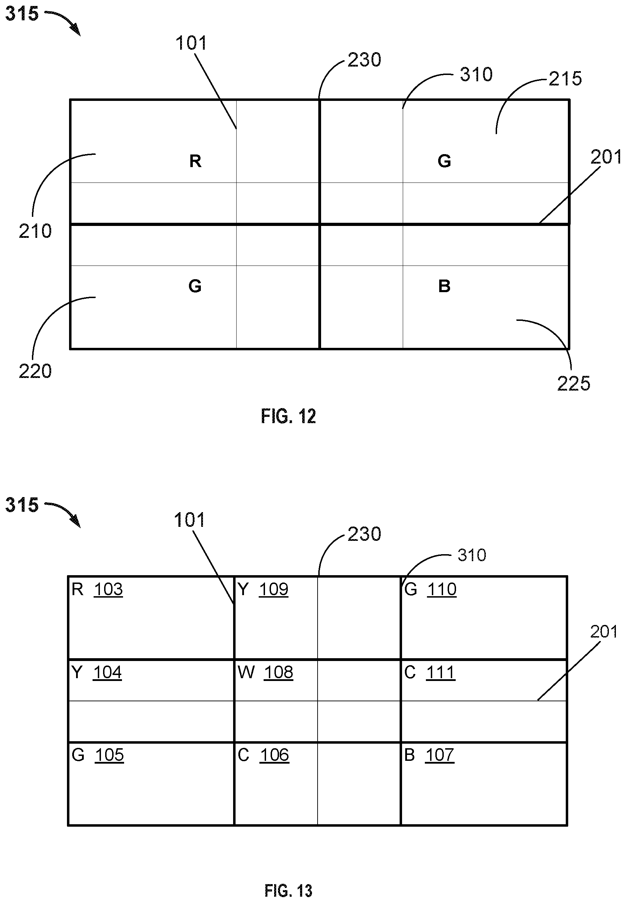

Figure 12 comprises an example 2x2 arrangement, an example pattern of color filter elements **230** that are 1.5x the size of the associated pixels, the pixels having an aspect ratio of 2:1. This example pattern of recurring filter elements **230** is represented by four squares (emphasized using thick borders around each filter element), each square representing an individual filter **201** in an array of four color filters, the top left filter (e.g., first filter element **210)** containing a letter R for red, the two immediately adjacent to the second filter element **215** and the third filter element **220** containing the letter G referring to green, and the fourth filter element **225** letter B referring to blue. The color labels of these filters generally representing the wavelength allowed to pass through each filter. The 2x2 color filter array of Figure 12 is disposed adjacent to the 3x3 array of nine sensors **310** such that the ratio of color filters to sensors is 1.5:1, resulting in the 2x2 arrangement of color filters substantially matching the 3x3 array of nine sensors **310.**

Figure 13 illustrates the concept discussed briefly above and in Figure 12 regarding the use of multiple color filters a sensor with a 2:1 aspect ratio. In this example embodiment, the 2x2 color filter array may overlay the 3x3 array of nine sensors **310** such that the ratio of color filters to sensors is 1.5:1. This results in the 2x2 arrangement of color filters substantially matching the 3x3 array of nine sensors **310.** Here, the first sensor **103** can be masked completely by a first filter element **210,** where the first filter element **210** may be configured to pass a spectrum of red light. Thus, a light sensing element of the first sensor **103** may be exposed to a spectrum of light that is limited by the first filter element **210.** A second sensor **104,** situated substantially below the first sensor **103,** may be masked by two CFA filter elements (in this example, the first filter element **210** and a second filter element **215**). Each CFA filter element may be positioned to mask portions of the second sensor **104.** In this example, the second sensor **104** may be exposed to a combination of green and red wavelengths resulting in a light spectrum that can be broad enough to include orange (590-620 nm wavelength), yellow (570-590 nm wavelength), and lighter shades of green (490-550 nm wavelength) to the second sensor **104.** A third sensor **109,** which lies adjacent and directly to the right of the first sensor **103,** may experience the same broad spectrum of light caused by a similar combination of filter elements. The third sensor **109** may be masked by the first filter element **210** and the second filter element **215.** Due to both the second sensor **104** and third sensor **109** experiencing a broader spectrum of radiation that may include the color yellow, both sensors are labeled with a "Y."

Figure 13 further illustrates a fourth sensor **105** on the bottom row of the 3x3 array of nine sensors **310** adjacent to, and directly below the second sensor **104.** The 2x2 filter matrix can be arranged so that the fourth sensor **105** is masked completely by the third filter element **220,** where the third filter element **220** may be configured to pass a spectrum of green light. Thus, a light sensing element of the fourth sensor **105** may be exposed to a spectrum of light that is limited by the third filter element **220.** A fifth sensor **110,** which lies adjacent and directly to the right of the third sensor **109,** may experience the same filtered light spectrum as the fourth sensor **105.** Due to both the fourth sensor **105** and fifth sensor **110** experiencing a spectrum of radiation that may be limited to the color green, both sensors are labeled with a "G."

Additionally, Figure 13 further illustrates a sixth sensor **106** on the bottom row of the 3x3 array of nine sensors **310** adjacent and directly to the right (in the orientation of Figure 8) of the fourth sensor **105.** The sixth sensor **106** can be masked by two individual CFA filters (in this example, the third filter element **220** and the fourth filter element **225**). Each CFA filter element may be positioned to mask portions of the sixth sensor **106.** In this example, the sixth sensor **106** may be exposed to a combination of green and blue wavelengths resulting in a light spectrum that can be broad enough to include the color cyan. A seventh sensor **111,** which lies adjacent and directly below (in the orientation of Figure 8) the fifth sensor **110,** may experience the same broad spectrum of light caused by a similar combination of filter elements. The seventh sensor **111** can be masked by the second filter element **215** and the fourth filter element **225.** Due to both the sixth sensor **106** and seventh sensor **111** experiencing a broad spectrum of radiation that may include the color cyan, both sensors are labeled with a "C."

Figure 13 further illustrates an eighth sensor **107** on the bottom row of the 3x3 array of nine sensors **310** adjacent to, and directly below (in the orientation of Figure 8) the seventh sensor **111.** The 2x2 filter matrix can be arranged so that the eighth sensor **107** is masked completely by the fourth filter element **225,** where the fourth filter element **225** may be configured to pass a spectrum of blue light. Thus, a light sensing element of the eighth sensor **107** may be exposed to a spectrum of light that is limited by the fourth filter element **225.** Due to the eighth sensor **107** experiencing a spectrum of radiation that may be limited to the color blue, it is labeled with a "B."

Figure 13 illustrates a ninth sensor **108** in the center of the 3x3 array of nine sensors **310.** The 2x2 filter matrix can be arranged so that the ninth sensor **108** is masked 25% by the first filter element **210,** 25% by the second filter element **215,** 25% by the third filter element **220,** and 25% by the fourth filter element **225.** Thus, a light sensing element of the ninth sensor **108** may be exposed to a spectrum of light that is broader than the spectrum exposed to the remaining sensors in the 3x3 array of nine sensors **310.** Due to the broad spectrum of light that the ninth sensor **108** may be exposed to, it is labeled with a "W" indicating that the pixel may be exposed to a mixture of the frequencies allowed by the filter elements.

### Implementing Systems and Terminology

Implementations disclosed herein provide systems, methods and apparatus for using values received from imaging diodes to calculate values for use in a phase detection autofocus process. One skilled in the art will recognize that these embodiments may be implemented in hardware, software, firmware, or any combination thereof.

In some embodiments, the circuits, processes, and systems discussed above may be utilized in a wireless communication device. The wireless communication device may be a kind of electronic device used to wirelessly communicate with other electronic devices. Examples of wireless communication devices include cellular telephones, smart phones, Personal Digital Assistants (PDAs), e-readers, gaming systems, music players, netbooks, wireless modems, laptop computers, tablet devices, etc.

The wireless communication device may include one or more image sensors, two or more image signal processors, a memory including instructions or modules for carrying out the process discussed above. The device may also have data, a processor loading instructions and/or data from memory, one or more communication interfaces, one or more input devices, one or more output devices such as a display device and a power source/interface. The wireless communication device may additionally include a transmitter and a receiver. The transmitter and receiver may be jointly referred to as a transceiver. The transceiver may be coupled to one or more antennas for transmitting and/or receiving wireless signals.

The wireless communication device may wirelessly connect to another electronic device (e.g., base station). A wireless communication device may alternatively be referred to as a mobile device, a mobile station, a subscriber station, a user equipment (UE), a remote station, an access terminal, a mobile terminal, a terminal, a user terminal, a subscriber unit, etc. Examples of wireless communication devices include laptop or desktop computers, cellular phones, smart phones, wireless modems, e-readers, tablet devices, gaming systems, etc. Wireless communication devices may operate in accordance with one or more industry standards such as the 3rd Generation Partnership Project (3GPP). Thus, the general term "wireless communication device" may include wireless communication devices described with varying nomenclatures according to industry standards (e.g., access terminal, user equipment (UE), remote terminal, etc.).

The functions described herein may be stored as one or more instructions on a processor-readable or computer-readable medium. The term "computer-readable medium" refers to any available medium that can be accessed by a computer or processor. By way of example, and not limitation, such a medium may comprise RAM, ROM, EEPROM, flash memory, CD-ROM or other optical disk storage, magnetic disk storage or other magnetic storage devices, or any other medium that can be used to store desired program code in the form of instructions or data structures and that can be accessed by a computer. Disk and disc, as used herein, includes compact disc (CD), laser disc, optical disc, digital versatile disc (DVD), floppy disk and Blu-ray® disc where disks usually reproduce data magnetically, while discs reproduce data optically with lasers. It should be noted that a computer-readable medium may be tangible and non-transitory. The term "computer-program product" refers to a computing device or processor in combination with code or instructions (e.g., a "program") that may be executed, processed or computed by the computing device or processor. As used herein, the term "code" may refer to software, instructions, code or data that is/are executable by a computing device or processor.

The methods disclosed herein comprise one or more steps or actions for achieving the described method. The method steps and/or actions may be interchanged with one another without departing from the scope of the claims. In other words, unless a specific order of steps or actions is required for proper operation of the method that is being described, the order and/or use of specific steps and/or actions may be modified without departing from the scope of the claims.

It should be noted that the terms "couple," "coupling," "coupled" or other variations of the word couple as used herein may indicate either an indirect connection or a direct connection. For example, if a first component is "coupled" to a second component, the first component may be either indirectly connected to the second component or directly connected to the second component. As used herein, the term "plurality" denotes two or more. For example, a plurality of components indicates two or more components.

The term "determining" encompasses a wide variety of actions and, therefore, "determining" can include calculating, computing, processing, deriving, investigating, looking up (e.g., looking up in a table, a database or another data structure), ascertaining and the like. Also, "determining" can include receiving (e.g., receiving information), accessing (e.g., accessing data in a memory) and the like. Also, "determining" can include resolving, selecting, choosing, establishing and the like.

The phrase "based on" does not mean "based only on," unless expressly specified otherwise. In other words, the phrase "based on" describes both "based only on" and "based at least on."

In the foregoing description, specific details are given to provide a thorough understanding of the examples. However, it will be understood by one of ordinary skill in the art that the examples may be practiced without these specific details. For example, electrical components/devices may be shown in block diagrams in order not to obscure the examples in unnecessary detail. In other instances, such components, other structures and techniques may be shown in detail to further explain the examples.

## Claims

1. A sensing device, comprising:
a sensor array comprising a plurality of sensors, each sensor (101) having a length dimension and a width dimension and configured to generate a signal responsive to radiation incident on the sensor; and
a filter array comprising a plurality of filters, each filter (201) having a length dimension and a width dimension, the filter array disposed to filter light before it is incident on the sensor array, the filter array arranged relative to the sensor array such that,
a first sensor (103) of the sensor array receives radiation propagating through a first filter, and
a second sensor (104) of the sensor array receives radiation propagating through at least the first filter and a second filter, wherein the first filter and the second filter are each configured to pass a different range of wavelength;
wherein a ratio of the length dimension of each filter to the length dimension of a corresponding sensor that receives light propagating through the filter, a ratio of the width dimension of each filter to the width dimension of a corresponding sensor that receives light propagating through the filter, or both, is a non-integer greater than 1.

2. The sensing device of claim 1, wherein the filter array comprises a repeated arrangement of filters, the repeated arrangement including:
a first filter having a first length and width dimension, configured to pass a first range of wavelengths;
a second filter having a second length and width dimension, configured to pass a second range of wavelengths;
a third filter having a third length and width dimension, configured to pass a third range of wavelengths; and
a fourth filter having a fourth length and width dimension, configured to pass any of the first, second, or third ranges of wavelengths.

3. The sensing device of claim 2, wherein the repeated arrangement of filters are arranged so that the first filter is disposed over a first sensor and over at least a portion of at least three other sensors adjacent to the first sensor.

4. The sensing device of claim 1, wherein the ratio of the length dimension of a filter to the length dimension of a corresponding sensor is a non-integer greater than 1.

5. The sensing device of claim 1, wherein a ratio of the width dimension of a filter to the width dimension of a corresponding sensor is a non-integer greater than 1.

6. The sensing device of claim 2, wherein at least some of the plurality of sensors are positioned relative to the filter elements to receive radiation filtered by no more than two of the first, second, third and fourth filters.

7. The sensing device of claim 2, wherein the length dimensions of the first filter, the second filter, the third filter, and the fourth filter are equal.

8. The sensing device of claim 2, wherein the width dimensions of the first filter, the second filter, the third filter, and the fourth filter are equal.

9. The sensing device of claim 2, wherein:
the first filter passes light wavelengths in a range of about 570 nm to about 750 nm;
the second filter passes light wavelengths in a range of about 450 nm to about 590 nm; and
the third filter passes light wavelengths in a range of about 380 nm to about 570 nm.

10. The sensing device of claim 1, wherein the filter array comprises a polymeric material.

11. The sensing device of claim 1, wherein the ratio of the length dimension of a filter and the length dimension of a corresponding sensor is between 1.0 and 2.0, or wherein the ratio of the width dimension of a filter and the width dimension of a corresponding sensor is between 1.0 and 2.0.

12. A method, comprising:
filtering light propagating towards a sensor array with a filter array comprising a plurality of filters, the filter array positioned relative to the sensor array to filter the light before it is incident on the sensor array, each filter (201) having a length dimension and a width dimension,
receiving the filtered light on the sensor array, the sensor array comprising a plurality of sensors (101) each configured to generate a signal responsive to light incident on the sensor, the sensor array arranged relative to the filter array such that
a first sensor (103) of the sensor array receives radiation propagating through a first filter, and
a second sensor (104) of the sensor array receives radiation propagating through at least the first filter and a second filter, wherein the first filter and the second filter are each configured to pass a different range of filtered light;
wherein each sensor having a length dimension and a width dimension, and
wherein a ratio of the length dimension of each filter to the length dimension of a corresponding sensor that receives light propagating through the filter, a ratio of the width dimension of each filter to the width dimension of a corresponding sensor that receives light propagating through the filter, or both, is a non-integer greater than 1.

13. The method of claim 12, wherein the filter array comprises a repeated arrangement of filters, the repeated arrangement including:
a first filter having a first length and width dimension, configured to pass a first range of wavelengths;
a second filter having a second length and width dimension, configured to pass a second range of wavelengths;
a third filter having a third length and width dimension, configured to pass a third range of wavelengths; and
a fourth filter having a fourth length and width dimension, configured to pass any of the first, second, or third ranges of wavelengths.

14. The method of claim 13, wherein the repeated arrangement of filters are arranged so that the first filter is disposed over a first sensor and over at least a portion of at least three other sensors adjacent to the first sensor.

15. The method of claim 13, wherein:
the first filter passes light wavelengths in a range of about 570 nm to about 750 nm;
the second filter passes light wavelengths in a range of about 450 nm to about 590 nm; and
the third filter passes light wavelengths in a range of about 380 nm to about 570 nm.

## Patentansprüche

1. Sensorvorrichtung, die Folgendes umfasst:
ein Sensor-Array, das mehrere Sensoren umfasst, wobei jeder Sensor (101) eine Längenabmessung und eine Breitenabmessung hat und zum Erzeugen eines Signals konfiguriert ist, das auf auf den Sensor einfallende Strahlung anspricht; und
ein Filter-Array, das mehrere Filter umfasst, wobei jedes Filter (201) eine Längenabmessung und eine Breitenabmessung hat, wobei das Filter-Array zum Filtern von Licht ausgelegt ist, bevor es auf das Sensor-Array einfällt, wobei das Filter-Array relativ zum Sensor-Array so angeordnet ist, dass ein erster Sensor (103) des Sensor-Array sich durch ein erstes Filter ausbreitende Strahlung empfängt, und
ein zweiter Sensor (104) des Sensor-Array sich durch das wenigstens erste Filter und ein zweites Filter ausbreitende Strahlung empfängt, wobei das erste Filter und das zweite Filter jeweils zum Durchlassen eines anderen Wellenlängenbereichs konfiguriert sind;
wobei ein Verhältnis zwischen der Längenabmessung jedes Filters und der Längenabmessung eines entsprechenden Sensors, der sich durch das Filter ausbreitendes Licht empfängt, ein Verhältnis zwischen der Breitenabmessung jedes Filters und der Breitenabmessung eines entsprechenden Sensors, der sich durch das Filter ausbreitendes Licht empfängt, oder beide, ein nicht ganzzahliger Wert größer als 1 ist.

2. Sensorvorrichtung nach Anspruch 1, wobei das Filter-Array eine wiederholte Anordnung von Filtern umfasst, wobei die wiederholte Anordnung Folgendes beinhaltet:
ein erstes Filter mit einer ersten Längen- und Breitenabmessung, konfiguriert zum Durchlassen eines ersten Wellenlängenbereichs;
ein zweites Filter mit einer zweiten Längen- und Breitenabmessung, konfiguriert zum Durchlassen eines zweiten Wellenlängenbereichs;
ein drittes Filter mit einer dritten Längen- und Breitenabmessung, konfiguriert zum Durchlassen eines dritten Wellenlängenbereichs; und
ein viertes Filter mit einer vierten Längen- und Breitenabmessung, konfiguriert zum Durchlassen von beliebigen aus dem ersten, zweiten oder dritten Wellenlängenbereich.

3. Sensorvorrichtung nach Anspruch 2, wobei die wiederholte Anordnung von Filtern so angeordnet ist, dass das erste Filter über einem ersten Sensor und über wenigstens einem Teil von wenigstens drei anderen Sensoren neben dem ersten Sensor angeordnet ist.

4. Sensorvorrichtung nach Anspruch 1, wobei das Verhältnis zwischen der Längenabmessung eines Filters und der Längenabmessung eines entsprechenden Sensors ein nicht ganzzahliger Wert größer als 1 ist.

5. Sensorvorrichtung nach Anspruch 1, wobei ein Verhältnis zwischen der Breitenabmessung eines Filters und der Breitenabmessung eines entsprechenden Sensors ein nicht ganzzahliger Wert größer als 1 ist.

6. Sensorvorrichtung nach Anspruch 2, wobei wenigstens einige der mehreren Sensoren relativ zu den Filterelementen zum Empfangen von durch nicht maximal zwei aus erstem, zweitem, drittem und viertem Filter gefilterter Strahlung positioniert sind.

7. Sensorvorrichtung nach Anspruch 2, wobei die Längenabmessungen des ersten Filters, des zweiten Filters, des dritten Filters und des vierten Filters gleich sind.

8. Sensorvorrichtung nach Anspruch 2, wobei die Breitenabmessungen des ersten Filters, des zweiten Filters, des dritten Filters und des vierten Filters gleich sind.

9. Sensorvorrichtung nach Anspruch 2, wobei:
das erste Filter Lichtwellenlängen in einem Bereich von etwa 570 nm bis etwa 750 nm durchlässt;
das zweite Filter Lichtwellenlängen in einem Bereich von etwa 450 nm bis etwa 590 nm durchlässt; und
das dritte Filter Lichtwellenlängen in einem Bereich von etwa 380 nm bis etwa 570 nm durchlässt.

10. Sensorvorrichtung nach Anspruch 1, wobei das Filter-Array ein Polymermaterial umfasst.

11. Sensorvorrichtung nach Anspruch 1, wobei das Verhältnis zwischen der Längenabmessung eines Filters und der Längenabmessung eines entsprechenden Sensors zwischen 1,0 und 2,0 liegt oder wobei das Verhältnis zwischen der Breitenabmessung eines Filters und der Breitenabmessung eines entsprechenden Sensors zwischen 1,0 und 2,0 liegt.

12. Verfahren, das Folgendes beinhaltet:
Filtern von Licht, das sich in Richtung eines Sensor-Array ausbreitet, mit einem Filter-Array, das mehrere Filter umfasst, wobei das Filter-Array relativ zum Sensor-Array zum Filtern des Lichts positioniert ist, bevor es auf das Sensor-Array einfällt, wobei jedes Filter (201) eine Längenabmessung und eine Breitenabmessung hat,
Empfangen des gefilterten Lichts auf dem Sensor-Array, wobei das Sensor-Array mehrere Sensoren (101) umfasst, die jeweils zum Erzeugen eines Signals als Reaktion auf auf den Sensor einfallendes Licht konfiguriert sind, wobei das Sensor-Array relativ zum Filter-Array so angeordnet ist, dass ein erster Sensor (103) des Sensor-Array sich durch ein erstes Filter ausbreitende Strahlung empfängt, und
ein zweiter Sensor (104) des Sensor-Array sich durch wenigstens das erste Filter und ein zweites Filter ausbreitende Strahlung empfängt, wobei das erste Filter und das zweite Filter jeweils zum Durchlassen eines anderen Bereichs von gefiltertem Licht konfiguriert sind;
wobei jeder Sensor eine Längenabmessung und eine Breitenabmessung hat, und
wobei ein Verhältnis zwischen der Längenabmessung jedes Filters und der Längenabmessung eines entsprechenden Sensors, der sich durch das Filter ausbreitendes Licht empfängt, ein Verhältnis zwischen der Breitenabmessung jedes Filters und der Breitenabmessung eines entsprechenden Sensors, der sich durch das Filter ausbreitendes Licht empfängt, oder beide, ein nicht ganzzahliger Wert größer als 1 ist.

13. Verfahren nach Anspruch 12, wobei das Filter-Array eine wiederholte Anordnung von Filtern umfasst, wobei die wiederholte Anordnung Folgendes beinhaltet:
ein erstes Filter mit einer ersten Längen- und Breitenabmessung, konfiguriert zum Durchlassen eines ersten Wellenlängenbereichs;
ein zweites Filter mit einer zweiten Längen- und Breitenabmessung, konfiguriert zum Durchlassen eines zweiten Wellenlängenbereichs;
ein drittes Filter mit einer dritten Längen- und Breitenabmessung, konfiguriert zum Durchlassen eines dritten Wellenlängenbereichs; und
ein viertes Filter mit einer vierten Längen- und Breitenabmessung, konfiguriert zum Durchlassen von beliebigen aus dem ersten, zweiten und dritten Wellenlängenbereich.

14. Verfahren nach Anspruch 13, wobei die wiederholte Anordnung von Filtern so angeordnet ist, dass das erste Filter über einem ersten Sensor und über wenigstens einem Teil von wenigstens drei anderen Sensoren neben dem ersten Sensor angeordnet ist.

15. Verfahren nach Anspruch 13, wobei:
das erste Filter Lichtwellenlängen in einem Bereich von etwa 570 nm bis etwa 750 nm durchlässt;
das zweite Filter Lichtwellenlängen in einem Bereich von etwa 450 nm bis etwa 590 nm durchlässt; und
das dritte Filter Lichtwellenlängen in einem Bereich von etwa 380 nm bis etwa 570 nm durchlässt.

## Revendications

1. Dispositif capteur, comprenant :
une matrice de capteurs comprenant une pluralité de capteurs, chaque capteur §101) ayant une dimension de longueur et une dimension de largeur et étant configuré pour générer un signal en réponse à un rayonnement frappant le capteur ; et
une matrice de filtres comprenant une pluralité de filtres, chaque filtre (201) ayant une dimension de longueur et une dimension de largeur, la matrice de filtres étant disposée pour filtrer la lumière avant qu'elle ne frappe la matrice de capteurs, la matrice de filtres étant agencée par rapport à la matrice de capteurs de telle sorte que,
un premier capteur (103) de la matrice de capteurs reçoive un rayonnement se propageant à travers un premier filtre, et
un deuxième capteur (104) de la matrice de capteurs reçoive un rayonnement se propageant à travers au moins le premier filtre et un deuxième filtre, le premier filtre et le deuxième filtre étant chacun configurés pour passer une plage de longueurs d'onde différente ;
dans lequel un rapport de la dimension de longueur de chaque filtre sur la dimension de longueur d'un capteur correspondant qui reçoit une lumière se propageant à travers le filtre, un rapport de la dimension de largeur de chaque filtre sur la dimension de largeur d'un capteur correspondant qui reçoit la lumière se propageant à travers le filtre, ou les deux, est un nombre non entier supérieur à 1.

2. Dispositif capteur selon la revendication 1, dans lequel la matrice de filtres comprend un agencement répété de filtres, l'agencement répété comportant :
un premier filtre ayant une première dimension de longueur et de largeur, configuré pour passer une première plage de longueurs d'onde ;
un deuxième filtre ayant une deuxième dimension de longueur et de largeur, configuré pour passer une deuxième plage de longueurs d'onde ;
un troisième filtre ayant une troisième dimension de longueur et de largeur, configuré pour passer une troisième plage de longueurs d'onde ; et
un quatrième filtre ayant une quatrième dimension de longueur et de largeur, configuré pour passer n'importe laquelle des première, deuxième ou troisième plages de longueurs d'onde.

3. Dispositif capteur selon la revendication 2, dans lequel l'agencement répété de filtres est agencé de telle sorte que le premier filtre soit disposé par-dessus un premier capteur et par-dessus au moins une partie d'au moins trois autres capteurs adjacents au premier capteur.

4. Dispositif capteur selon la revendication 1, dans lequel le rapport de la dimension de longueur d'un filtre sur la dimension de longueur d'un capteur correspondant est un nombre non entier supérieur à 1 .

5. Dispositif capteur selon la revendication 1, dans lequel un rapport de la dimension de largeur d'un filtre sur la dimension de largeur d'un capteur correspondant est un nombre non entier supérieur à 1 .

6. Dispositif capteur selon la revendication 2, dans lequel au moins certains de la pluralité de capteurs sont positionnés par rapport aux éléments de filtre pour recevoir un rayonnement filtré par pas plus de deux des premier, deuxième, troisième et quatrième filtres.

7. Dispositif capteur selon la revendication 2, dans lequel les dimensions de longueur du premier filtre, du deuxième filtre, du troisième filtre et du quatrième filtre sont égales.

8. Dispositif capteur selon la revendication 2, dans lequel les dimensions de largeur du premier filtre, du deuxième filtre, du troisième filtre et du quatrième filtre sont égales.

9. Dispositif capteur selon la revendication 2, dans lequel :
le premier filtre passe des longueurs d'onde de lumière dans une plage d'environ 570 nm à environ 750 nm;
le deuxième filtre passe des longueurs d'onde de lumière dans une plage d'environ 450 nm à environ 590 nm ; et
le troisième filtre passe des longueurs d'onde de lumière dans une plage d'environ 380 nm à environ 570 nm.

10. Dispositif capteur selon la revendication 1, dans lequel la matrice de filtres comprend un matériau polymérique.

11. Dispositif capteur selon la revendication 1, dans lequel le rapport de la dimension de longueur d'un filtre et de la dimension de longueur d'un capteur correspondant est comprise entre 1,00 et 2,0, ou dans lequel le rapport de la dimension de largeur d'un filtre et de la dimension de largeur d'un capteur correspondant est compris entre 1,0 et 2,0.

12. Procédé comprenant :
le filtrage d'une lumière se propageant vers une matrice de capteurs avec une matrice de filtres comprenant une pluralité de filtres, la matrice de filtres étant positionnée par rapport à la matrice de capteurs pour filtrer la lumière avant qu'elle ne frappe la matrice de capteurs, chaque filtre(201) ayant une dimension de longueur et une dimension de largeur,
la réception de la lumière filtrée sur la matrice de capteurs, la matrice de capteurs comprenant une pluralité de capteurs (101) configurés chacun pour générer un signal en réponse à la lumière frappant le capteur, la matrice de capteurs étant agencée par rapport à la matrice de filtres de telle sorte que
un premier capteur (103) de la matrice de capteurs reçoive un rayonnement se propageant à travers un premier filtre, et
un deuxième capteur (104) de la matrice de capteurs reçoive un rayonnement se propageant à travers au moins le premier filtre et un deuxième filtre, le premier filtre st le deuxième filtre étant chacun configurés pour passer une plage différente de lumière filtrée;
dans lequel chaque capteur a une dimension de longueur et une dimension de largeur, et
dans lequel un rapport de la dimension de longueur de chaque filtre sur la dimension de longueur d'un capteur correspondant qui reçoit une lumière se propageant à travers le filtre, un rapport de la dimension de largeur de chaque filtre sur la dimension de largeur d'un capteur correspondant qui reçoit la lumière se propageant à travers le filtre, ou les deux, est un nombre non entier supérieur à 1.

13. Procédé selon la revendication 12, dans lequel la matrice de filtres comprend un agencement répété de filtres, l'agencement répété comportant :
un premier filtre ayant une première dimension de longueur et de largeur, configuré pour passer une première plage de longueurs d'onde ;
un deuxième filtre ayant une deuxième dimension de longueur et de largeur, configuré pour passer une deuxième plage de longueurs d'onde ;
un troisième filtre ayant une troisième dimension de longueur et de largeur, configuré pour passer une troisième plage de longueurs d'onde ; et
un quatrième filtre ayant une quatrième dimension de longueur et de largeur, configuré pour passer n'importe laquelle des première, deuxième ou troisième plages de longueurs d'onde.

14. Procédé selon la revendication 13, dans lequel l'agencement répété de filtres est agencé de telle sorte que le premier filtre soit disposé par-dessus un premier capteur et par-dessus au moins une partie d'au moins trois autres capteurs adjacents au premier capteur.

15. Procédé selon la revendication 13, dans lequel:
le premier filtre passe des longueurs d'onde de lumière dans une plage d'environ 570 nm à environ 750 nm;
le deuxième filtre passe des longueurs d'onde de lumière dans une plage d'environ 450 nm à environ 590 nm ; et
le troisième filtre passe des longueurs d'onde de lumière dans une plage d'environ 380 nm à environ 570 nm.
